# EUROPÄISCHE PATENTSCHRIFT

(11) **EP 0 999 583 B1**
(45) Veröffentlichungstag und Bekanntmachung des Hinweises auf die Patenterteilung: **18.02.2009**
(21) Anmeldenummer: 99203540.2
(22) Anmeldetag: 27.10.1999
(51) Int. Cl.: H01L 21/302

(54) **Stabilisierung eines Substrats mittels Trägerelement**
Increasing stability of a substrate by a supporting element
Amélioration de la stabilité d'un substrat par un élément support

(30) Priorität: 05.11.1998 DE 19850873
(43) Veröffentlichungstag der Anmeldung: 10.05.2000
(73) Patentinhaber: NXP B.V., 5656 AG Eindhoven (NL)
(72) Erfinder: Anker, Joachim, C/o Philips Corp. Int. Prop. GmbH, 52064 Aachen (DE); Dichte, Olaf, C/o Philips Corp. Int. Prop. GmbH, 52064 Aachen (DE); Burmeister, Frank, C/o Philips Corp. Int.Prop.GmbH, 52064 Aachen (DE)
(74) Vertreter: van der Veer, Johannis Leendert

(56) Entgegenhaltungen:
- DE-A- 2 431 987
- DE-A- 3 040 675
- DE-A- 3 639 266
- US-A- 3 783 499
- US-A- 3 924 323
- US-A- 4 138 304
- US-A- 4 722 130
- US-A- 4 961 804
- US-A- 5 321 303
- US-A- 5 527 744
- US-A- 5 534 102
- PATENT ABSTRACTS OF JAPAN vol. 018, no. 461 (E-1597), 26. August 1994 (1994-08-26) & JP 06 151585 A (MURATA MFG CO LTD), 31. Mai 1994 (1994-05-31)

## Beschreibung

Die Erfindung bezieht sich auf ein Verfahren zum Bearbeiten eines im wesentlichen scheibenförmigen Erzeugnisses der Halbleitertechnik gemäß dem Oberbegriff des unabhängigen Anspruchs.

Aus der europäischen Patentanmeldung 0 800 205 ist ein Verfahren zum Vereinzeln von in einem Körper miteinander verbundenen elektronischen Elementen bekannt, bei dem die von den elektronischen Elementen abgewandte Seite des Körpers abgedünnt wird, die elektronischen Elemente voneinander getrennt werden und elektrische Parameter der elektronischen Elemente nach dem Abdünnen des Körpers getestet werden. Die Handhabung des Körpers soll dadurch verbessert werden, daß auf die die elektronischen Elemente aufweisende Seite des Körpers vor dem Abdünnen eine elektrisch nicht leitende Hilfsschicht aufgebracht wird, in welcher über den elektronischen Elementen jeweils eine Kontaktöffnung, die den/die Kontakt/e des jeweiligen elektronischen Elements frei legt, ausgebildet wird. Nachdem die elektrischen Parameter der elektronischen Elemente getestet sind, werden die elektronischen Elemente, die weiter verwendet werden sollen, ausgewählt und einer Vorrichtung zur weiteren Verarbeitung zugeführt. Bis dahin sind die elektronischen Elemente noch durch Stege in der Hilfsschicht miteinander verbunden. In der genannten Vorrichtung müssen diese Stege der Hilfsschicht entfernt werden, so daß die elektronischen Elemente auch mechanisch voneinander getrennt sind. Die Hilfsschicht verbleibt auf der die elektronischen Elemente aufweisenden Seite des Körpers. Dadurch behalten die elektronischen Elemente insgesamt ohne die Vornahme weiterer Bearbeitungsschritte eine größere Bauhöhe, als sie dies ohne die genannte Hilfsschicht haben könnten. Außerdem erfordert die Hilfsschicht zusätzliche, speziell auf sie abgestimmte Bearbeitungsschritte, nämlich die Herstellung der Kontaktöffnungen und der Stege sowie deren Durchtrennung. Darüber hinaus ist es bei diesem Verfahren erforderlich, den die elektronischen Elemente tragenden Körper von der diesen Elementen abgewandten Seite zum Vereinzeln der Elemete zu trennen. Diese Trennung von unten", die beispielsweise durch Ätzen erfolgen soll, macht jedoch insbesondere bei kleinen Strukturen der elektronischen Elemente einen hohen Aufwand erforderlich, um für die Positionierung der Einkerbungen eine hinreichend präzise Justage zu gewährleisten. Würde statt des Ätzens ein Sägeprozeß vorgenommen, träte der zusätzliche Nachteil auf, daß beim Sägen häufig die vom Sägeblatt abgewandte Oberfläche des Körpers zum Abbröckeln neigt und daß in diesem Fall die durch das Abbröckeln gefährdete Oberfläche die elektronischen Elemente trägt. Dies würde zusätzlich die Ausschußrate erhöhen.

Aus der englischsprachigen Kurzzusammenfassung der Druckschrift JP 61-8938 (A) ist ein Verfahren bekannt, bei dem ein Wafer mit Halbleiterelementen auf ein thermoelastisches adhäsives Band geklebt wird. Durch Dehnen des Bandes werden die Elemente voneinander getrennt, anschließend elektrisch vermessen und vom Band entfernt. Insbesondere bei sehr feinen Leiterstrukturen auf den Halbleiterelementen können jedoch nach dem Trennen die elektrischen Messungen nur noch für einzelne Elemente ausgeführt werden, da durch die Ausdehung des Bandes die exakte geometrische Ausrichtung der Elemente zueinander nicht mehr gewährleistet ist. Damit sind einerseits Mehrfachtests, d.h. gleichzeitige elektrische Messungen mehrerer Elemente eines Wafers, nicht mehr oder nur mit Vorrichtungen möglich, die umfangreiche und komplizierte Justiervorgänge benötigen.

Aus der englischsprachigen Kurzzusammenfassung der Druckschrift JP 5-341000 (A) ist ein Verfahren bekannt, bei dem integrierte Schaltungen nach Auftrennen eines Wafers einzeln aufgenommen werden und einem individuellen Test unterzogen werden. Danach werden die integrierten Schaltungen an bestimmten Positionen auf einem neuen Träger abgelegt und auf diesem einem weiteren, abschließenden Test unterzogen. Hier ergibt sich für die Anordnung der integrierten Schaltungen auf dem weiteren Träger ein sehr hoher Justieraufwand, ganz abgesehen von dem individuell durchgeführten Testschritt.

Aus dem US-Patent 5,456,404 ist weiterhin ein ähnliches Verfahren bekannt zum Testen von Halbleiterschaltungen. In diesem Verfahren wird ein besonderes Testgehäuse verwendet, in dem die Schaltungen einzelnen kontaktiert und getestet werden. Durch eine spezielle Ausgestaltung der Kontakte des Testgehäuse soll erreicht werden, daß im Fall eines positiv verlaufenden elektrischen Tests durch Erhöhung des Anpreßdrucks der elektronischen Schaltung im Testgehäuse die Schaltung endgültig in dem Gehäuse fixiert und somit das Testgehäuse gleichzeitig als dauerhaftes Gehäuse für die integrierte Schaltung verwendet werden kann. Dies bedingt jedoch ebenfalls einen hohen Aufwand beim Testen und für die Gehäuse.

Aus der US-A-3 924 323 ist ein Verfahren zur Herstellung einer Vielzahl von Halbleiterchips bzw. -schaltungen auf einer Halbleiterscheibe, auch als "Wafer" bezeichnet, bekannt. Dabei werden Rillen in die Rückseite eines auf einem Fräger aufgebrachten Wafers derart eingebracht, daß einzelne Schaltungen voneinander getrennt werden. Vorzugsweise erstrecken sich die Rillen nicht vollständig durch das Wafer hindurch. Die Rillen werden dann mit Kunstharz gefüllt, durch das die Schaltungen voneinander isoliert werden, und die Rückseite des Wafers wird ebenfalls mit Kunstharz bedeckt. Später wird das jeder Rille gegenüberliegende Halbleitermaterial entfernt und das Wafer derart aufgetrennt, daß jede Chip-Einheit eine Mehrzahl isolierter Schaltungen aufweist.

Die Erfindung hat die Aufgabe, ein Verfahren der eingangs genannten Art in der Weise auszugestalten, daß für eine kostengünstige Herstellung von Erzeugnissen der Halbleitertechnik eine möglichst einfache Handhabung auch unter erhöhten Anforderungen möglich ist, die insbesondere durch immer weitere Verkleinerung der Leiterstrukturen der auf diesen Erzeugnissen gestalteten elektronischen Schaltungskörper gestellt werden.

Diese Aufgabe wird erfindungsgemäß bei einem Verfahren nach dem Oberbegriff des Patentanspruchs 1 durch die kennzeichnenden Merkmale des Anspruchs 1 gelöst.

Ein derartiges Erzeugnis der Halbleitertechnik im Sinne der erfindungsgemäßen Lehre ist bevorzugt eine Scheibe aus halbleitendem Werkstoff, beispielsweise aus dotiertem Silicium. Darüber hinaus können auch andere Werkstoffe zum Einsatz gelangen, und zwar sowohl elementare Stoffe wie auch Verbindungen, halbmetallische oder nicht metallische. Mit dem Begriff "Scheibe" soll im folgenden ein wenigstens nahezu zylindrischer Körper mit einer im Vergleich zu seinen Querschnittsabmessungen geringen Höhe verstanden werden. Unter "zylindrisch" wird dabei ein Körper verstanden, dessen senkrecht zu seiner Längsachse, der Zylinderachse, gemessener Querschnitt über seine gesamte Ausdehnung entlang dieser Zylinderachse eine wenigstens nahezu unveränderte Gestalt und Abmessung aufweist. Während die Querschnittsabmessungen des zylindrischen Körpers senkrecht zur Zylinderachse gemessen werden, wird die Höhe des zylindrischen Körpers parallel zur Zylinderachse gemessen. Die Hauptflächen einer derartigen Scheibe werden durch die Oberflächen des zylindrischen Körpers, die in Richtung der Zylinderachse nach außen weisen, gebildet. Diese Hauptflächen sollen bei einer Scheibe der beschriebenen Art wenigstens nahezu parallel zueinander verlaufen. Sie weisen dann eine Kontur auf, die wenigstens nahezu einer Querschnittsfläche durch den zylindrischen Körper rechtwinklig zu seiner Zylinderachse entspricht. Vorzugsweise werden in der Halbleitertechnik Scheiben mit wenigstens nahezu kreisförmigen Hauptflächen, sogenannte "Wafer" benutzt, auf deren erster Hauptfläche, auch als Oberseite bezeichnet, eine Anzahl von elektronischen Schaltungskörpern gestaltet wird, während auf der zweiten Hauptfläche, die der ersten Hauptfläche gegenüber liegt, in der Regel allenfalls eine passivierende oder leitende Schicht aufgebracht wird. Diese zweite Hauptfläche wird dann auch als Unterseite des Wafers bezeichnet.

Durch das Aufbringen eines beschriebenen Erzeugnisses der Halbleitertechnik auf ein Trägerelement wird es in einfacher Weise möglich, dieses Erzeugnis Bearbeitungsschritten in Fertigungseinrichtungen zu unterziehen, auch wenn das Erzeugnis für sich genommen aufgrund seiner Abmessungen oder Strukturen für die genannten Bearbeitungsschritte und/oder Fertigungseinrichtungen nicht geeignet ist. Dies gilt insbesondere für Erzeugnisse mit geometrisch besonders kleinen bzw. mechanisch nur gering belastbaren Strukturen, wie beispielsweise besonders dünnen Wafern oder elektronischen Schaltungskörpern mit Strukturen im Submikrometerbereich. Derartige Erzeugnisse werden beispielsweise für den Einsatz in Chipkarten benötigt und müssen dafür in sehr großer Stückzahl zu sehr geringem Preis herstellbar sein. Es ist dann wirtschaftlich von entscheidender Bedeutung, derartige Erzeugnisse mit einfachen und billigen Standardverfahren in der Fertigung und auch in einer elektrischen Prüfung bearbeiten zu können. Dies wird mit der vorliegenden Erfindung dadurch möglich, daß das auf das Trägerelement aufgebrachte Erzeugnis in allen Bearbeitungsschritten wie eine einheitliche, d.h. ungetrennte, mechanisch stabile Scheibe bearbeitbar ist, wie im folgenden näher erläutert wird.

Je nach dem, welche der Hauptflächen des Erzeugnisses zu bearbeiten ist, wird adhäsives Material und Trägerelement zur flächigen Verbindung auf die jeweils andere der Hauptflächen des Erzeugnisses aufgebracht. Die Erfindung betrifft nämlich, ohne Beeinträchtigung der Eigenschaften des Erzeugnisses, insbesondere ohne Beeinträchtigung der mechanischen und/oder elektrischen Parameter auf der Oberseite gestalteter elektronischer Schaltungskörper, ein Aufbringen jeweils eines Trägerelements sowohl auf der Oberseite des Erzeugnisses als auch auf seiner Unterseite. Dabei wird ein Trägerelement mit adhäsivem Material auf der ersten Hauptfläche, d.h. der Oberseite, des Erzeugnisses aufgebracht, um es entlang seiner zweiten Hauptfläche, d.h. entlang der Unterseite, einem Bearbeitungsschritt zum vorzugsweise flächigen Materialabtrag zu unterziehen. Ein solcher Materialabtrag kann vorteilhaft durch Schleifen, Läppen oder Ätzen erfolgen und dient der Abdünnung des Erzeugnisses, d.h. des Wafers, auf die endgültige Substratdicke der auf dem Erzeugnis gestalteten elektronischen Schaltungskörper. Auch an dieses Abdünnen sich anschließende Bearbeitungsschritte werden vorzugsweise mit auf der Oberseite aufgebrachtem Trägerelement ausgeführt, da durch dieses die mechanische Stabilität des Erzeugnisses erhöht, d.h. eine Bruchempfindlichkeit vermindert ist. Für das Abdünnen und die auf dieses folgenden Bearbeitungsschritte können dann bevorzugt Einrichtungen verwendet werden, die auch für Erzeugnisse größerer Dicke vorgesehen sind und die eine einfache und preiswerte Bearbeitung ermöglichen, da eine besondere Bruchempfindlichkeit des Erzeugnisses nicht berücksichtigt werden muß.

Beim erfindungsgemäßen Verfahren wird nach Aufbringen des adhäsiven Materials und des Trägerelements auf der zweiten Hauptfläche, d.h. auf der Unterseite, das Erzeugnis entlang seiner ersten Hauptfläche (Oberseite) einem Bearbeitungsschritt zum mechanischen Trennen der elektronischen Schaltungskörper unterzogen. Dieses Trennen wird vorzugsweise durch Sägen vorgenommen. Auch das Aufbringen einer Maske und anschließendes Ätzen von Trennfugen ist beispielhaft möglich.

Beim erfindungsgemäßen Verfahren wird nach Aufbringen des adhäsiven Materials und des Trägerelements auf der zweiten Hauptfläche (Unterseite) und nach dem Trennen der Schaltungskörper das Erzeugnis einem elektrischen Prüfungsschritt der elektronischen Schaltungskörper unterzogen. Es wird dabei der elektrische Prüfungsschritt nach dem Bearbeitungsschritt zum mechanischen Trennen in derselben Weise wie für ein ungetrenntes Erzeugnis durchgeführt.

In dieser Ausgestaltung zeigt sich ein besonderer Vorteil des erfindungsgemäßen Verfahrens. Aufgrund der Möglichkeit, beim mechanischen Trennen, insbesondere durch Sägen, einzelne elektronische Schaltungskörper derart zu beschädigen, daß sie nicht funktionsfähig sind, ist es zur Erfassung dadurch entstehenden Ausschusses notwendig, den elektrischen Prüfungsschritt, zumindest den letzten elektrischen Prüfungsschritt, nach Abschluß sämtlicher Bearbeitungsschritte zur Fertigung der elektronischen Schaltungskörper vorzunehmen. Andererseits ergibt sich bei einem scheibenförmigen Erzeugnis vor dem Auftrennen in einzelne elektronische Schaltungskörper ein wesentlicher Vorteil für den elektrischen Prüfungsschritt dadurch, daß alle elektronischen Schaltungskörper geometrisch zueinander präzise positioniert sind. Gerade für elektronische Schaltungskörper mit sehr kleinen Strukturen müssen nämlich sehr enge Toleranzen eingehalten werden, um elektrische Kontaktvorrichtungen einer Einrichtung zum Durchführen elektrischer Prüfungsschritte einwandfrei mit Kontakteinrichtungen auf den elektronischen Schaltungskörpern in Verbindung zu bringen. Diese Toleranzen können eingehalten werden, wenn für eine individuelle Ausführung eines elektrischen Prüfungsschritts für jeden der elektronischen Schaltungskörper einzeln eine Justierung zwischen diesem elektronischen Schaltungskörper und der elektrischen Kontaktvorrichtung der Einrichtung zum Durchführen der elektrischen Prüfungsschritte vorgenommen wird. Dies führt aber zu einem sehr langwierigen und damit kostspieligen Ablauf der elektrischen Prüfung der elektronischen Schaltungskörper. Es werden daher gleichzeitige Prüfungen mehrerer elektronischer Schaltungskörper auf einem "Wafer" bevorzugt, wofür die elektrischen Kontaktvorrichtungen der Einrichtung zum Durchführen der elektrischen Prüfungsschritte zugleich mehrere elektronische Schaltungskörper kontaktieren müssen. Um dafür den Justieraufwand gering halten zu können, sind sowohl bei der Anordnung der elektrischen Kontaktvorrichtungen der Einrichtung zum Durchführen der elektrischen Prüfungsschritte als auch bei der geometrischen Anordnung der Kontakteinrichtungen auf den elektronischen Schaltungskörpern geringe Maßtoleranzen notwendig. Diese können nur dann sinnvoll eingehalten werden, wenn während der elektrischen Prüfungsschritte die elektronischen Schaltungskörper eine genau definierte Lage zueinander einnehmen. Diese Lage entspricht bevorzugt derjenigen auf dem ungetrennten Erzeugnis, also beispielsweise dem ungesägten Wafer.

Den sich aus diesen gegensätzlichen Forderungen ergebenden Konflikt löst die Erfindung auf sehr einfache und kostengünstige Weise. Durch die Verbindung zwischen dem Erzeugnis und dem Trägerelement behalten die elektronischen Schaltungskörper auch nach dem mechanischen Trennen ihre exakt definierten geometrischen Positionen bei. Dadurch kann der elektrische Prüfungsschritt nach dem mechanischen Trennen, also am vollkommen fertig gestellten Erzeugnis, mit denselben Vereinfachungen durchgeführt werden, wie es für ein ungetrenntes Erzeugnis (ungesägter Wafer) möglich ist, wobei die Handhabung bzw. fertigungsmechanische Manipulation der Erzeugnisse aufgrund der durch das Trägerelement gegebenen mechanischen Stabilität nur geringen Anforderungen unterliegt und somit preiswert vorzunehmen ist. Insbesondere können hierfür Einrichtungen verwendet werden, wie sie auch für die Behandlung ungetrennter Erzeugnisse größerer mechanischer Stabilität verwendet werden.

Außer der Möglichkeit, mehrere elektronische Schaltungskörper zugleich dem elektrischen Prüfungsschritt zu unterziehen, eröffnet die Erfindung auch die Möglichkeit, soweit gewünscht, die elektrischen Prüfungsschritte für alle elektronischen Schaltungskörper auf einem Erzeugnis zeitlich nacheinander auszuführen. Die Justierung wird dabei durch die Erfindung ebenfalls vereinfacht, da lediglich für den auf einem "Wafer" als ersten zu prüfenden elektronischen Schaltungskörper eine genaue Justierung gegenüber den elektrischen Kontaktvorrichtungen der Einrichtung zum Durchführen der elektrischen Prüfungsschritte vorzunehmen ist. Ohne weitere Justierung können dann diese elektrischen Kontaktvorrichtungen zum Prüfen der übrigen elektronischen Schaltungskörper des "Wafers" um definierte Abstände verschoben werden. Auch dieser Vorteil der Durchführung elektrischer Prüfungsschritte eines ungetrennten Erzeugnisses läßt sich durch Anwendung des erfindungsgemäßen Verfahrens auf ein Erzeugnis mit mechanisch voneinander getrennten elektronischen Schaltungskörpern ausdehnen.

Es ist erkennbar, daß diese Vorteile ein wenigstens weitgehend formstabiles Trägerelement erfordern. Die geforderte Formstabilität muß so beschaffen sein, daß während der Bearbeitungsschritte auftretende, auf das Trägerelement wirkende mechanische Kräfte nicht zu Verformungen des Trägerelements führen können, durch die die beschriebene Einhaltung der geforderten Toleranzen gefährdet ist oder durch die Beschädigungen des Erzeugnisses auftreten können. Diese Forderung unterscheidet die erfindungsgemäß eingesetzten Trägerelemente deutlich von den im Stand der Technik zum Trennen der elektronischen Schaltungskörper eingesetzten, dehnbaren Folien.

Andererseits ist erfindungsgemäß durchaus ein Trägerelement verwendbar, welches sich durch Einbringen mechanischer Kräfte, die während der vorbeschriebenen Bearbeitungsschritte des Erzeugnisses nicht auftreten, also hinreichend groß sind, in geringfügiger Weise derart verformen läßt, daß dadurch ein noch zu beschreibendes Trennen des Erzeugnisses vom Trägerelement erleichtert wird.

Eine derartige Trennung wird dadurch vorgenommen, daß beim erfindungsgemäßen Verfahren die Klebkraft des adhäsiven Materials durch Zufuhr von Wärmeenergie herabsetzbar ist. Nicht erfindungsgemäß könnte das adhäsive Material gegen ultraviolettes Licht empfindlich sein, so daß die Klebkraft durch Bestrahlung mit derartigem Licht herabgesetzt werden kann. Auch diese Ausbildung vereinfacht die Bearbeitung der beschriebenen Erzeugnisse, da die Bestrahlung mit ultraviolettem Licht in der Halbleiterfertigungstechnik weit verbreitet ist und somit auch zur Durchführung dieses Verfahrensschrittes keine besonderen Einrichtungen benötigt werden. Dieser Vorteil greift im übrigen auch für den Einsatz wärmeempfindlicher adhäsiver Materialien.

Als wärmeempfindliche adhäsive Materialien dienen solche, deren Klebkraft sich bei Überschreiten vorbestimmter Temperaturgrenzen vermindert, wobei diese Verminderung vorzugsweise irreversibel erfolgt, so daß nach Abkühlen der adhäsiven Materialien die Klebkraft herabgesetzt bleibt. Ferner ist es vorteilhaft, wenn zum Aufbringen der Trägerelemente auf die verschiedenen Hauptflächen eines Erzeugnisses der beschriebenen Art adhäsive Materialien verwendet werden, deren Klebkraft bei Überschreiten unterschiedlicher Temperaturgrenzen vermindert wird. Das bedeutet, daß bei gleichzeitigem Anwenden zweier solcher Materialien durch gezielte Temperaturerhöhung die Klebkraft des Materials mit der niedrigeren Temperaturgrenze vermindert werden kann, wohingegen die Klebkraft des anderen Materials noch nicht beeinträchtigt ist, so lange die erreichte Temperatur dessen Temperaturgrenze noch nicht überschritten hat.

Eine derartige Auswahl der adhäsiven Materialien wird für den Bearbeitungsschritt vorgenommen, bei dem zugleich auf beiden Hauptflächen des Erzeugnisses je ein Trägerelement mit adhäsivern Material aufgebracht ist, und eines dieser Trägerelemente ohne Beeinträchtigung der Verbindung des Erzeugnisses zum anderen Trägerelement abgelöst werden soll. Das adhäsive Material, mit dem das im Laufe der weiteren Bearbeitung zuerst zu entfernende Trägerelement aufgebracht ist, wird dann die niedrigere Temperaturgrenze aufweisen. Durch Wärmeeinwirkung kann dann gezielt nur dieses eine Trägerelement abgelöst, das andere jedoch am Erzeugnis belassen werden. Ein solcher Fall tritt insbesondere beim Wechsel von der Bearbeitung einer der Hauptflächen zur Bearbeitung der anderen Hauptfläche auf.

Das adhäsive Material kann in unterschiedlichen Verarbeitungsformen, beispielsweise als Flüssigkeit, aufgebracht werden. Bevorzugt liegt es jedoch als Folie vor, die beidseitig mit Klebemittel beschichtet ist. Eine derartige, doppelseitig klebende Folie kann leicht auf eine der Hauptflächen des Erzeugnisses auflaminiert werden. In einseitig klebender Beschichtung kann eine solche Folie auch als Schutzfolie Verwendung finden.

Wie bereits ausgeführt, werden nach dem erfindungsgemäßen Verfahren Trägerelemente auf beide Hauptflächen des Erzeugnisses aufgebracht. Dies kann gleichzeitig oder vorzugsweise nacheinander, d.h. abwechselnd auf der einen und der anderen Hauptfläche vorgenommen werden. Dadurch wird die Bearbeitung der Erzeugnisse insgesamt sehr vereinfacht. In einer bevorzugten Ausgestaltung der Erfindung kann ein Bearbeitungsverfahren die zeitlich aufeinander folgende Durchführung der nachstehenden Bearbeitungsschritte aufweisen:
a) flächiges Aufbringen eines ersten schichtförmigen, adhäsiven Materials auf die erste Hauptfläche des Erzeugnisses,
b) Aufbringen eines ersten Trägerelements auf das erste schichtförmige, adhäsive Material, durch welches zwischen der ersten Hauptfläche des Erzeugnisses und dem ersten Trägerelement eine flächige Verbindung gebildet wird,
c) mechanischer und/oder chemischer, vorzugsweise flächiger Materialabtrag auf der zweiten Hauptfläche des Erzeugnisses,
d) flächiges Aufbringen eines zweiten schichtförmigen adhäsiven Materials auf die zweite Hauptfläche des Erzeugnisses,
e) Aufbringen eines zweiten Trägerelements auf das zweite schichtförmige, adhäsive Material, durch welches zwischen der zweiten Hauptfläche des Erzeugnisses und dem zweiten Trägerelement eine flächige Verbindung gebildet wird,
f) Herabsetzen der Klebkraft des ersten schichtförmigen, adhäsiven Materials durch Zufuhr von Wärmeenergie,
g) Entfernen des ersten schichtförmigen, adhäsiven Materials und des ersten Trägerelements von der ersten Hauptfläche,
h) mechanisches Trennen der auf der ersten Hauptfläche ausgebildeten elektronischen Schaltungskörper, vorzugsweise durch Sägen des Erzeugnisses,
i) elektrische Funktionsprüfung der mechanisch getrennten elektronischen Schaltungskörper im Verbund ihrer gegenüber dem ungesägten Erzeugnis unveränderten, räumlichen Position auf dem zweiten Trägerelement und kenntlich machen unbrauchbarer elektronischer Schaltungskörper,
j) Herabsetzen der Klebkraft des zweiten schichtförmigen, adhäsiven Materials durch Zufuhr von Wärmeenergie, wobei für das Herabsetzen der Klebkraft beider adhäsiver Materialien durch Zufuhr von Wärmeenergie bei dem ersten adhäsiven Material zum Vermindern der Klebkraft eine niedrigere Temperaturgrenze zu überschreiten ist als beim zweiten adhäsiven Material,
k) Entfernen der einzelnen elektronischen Schaltungskörper vom zweiten Trägerelement.

Ein derartiger Bearbeitungsablauf benutzt in besonders vorteilhafter Weise das erfindungsgemäße Verfahren. In einfacher und preiswerter Weise ist dabei eine Bearbeitung der Unterseite des Erzeugnisses ohne Bruchgefährdung möglich. Die elektrische Funktionsprüfung erfordert keine Abänderung gegenüber herkömmlichen Funktionsprüfungen an einem Erzeugnis vor der mechanischen Trennung der elektronischen Schaltungskörper. Die Handhabung des Erzeugnisses erfolgt in allen Bearbeitungsschritten wie im ungetrennten Zustand. Die elektrische Funktionsprüfung kann nach dem Trennen als letzter Bearbeitungsschritt vor dem Verpacken und/oder Versand durchgeführt werden.

Auch eine Erweiterung der aufgeführten Bearbeitungsschritte ist sehr einfach möglich. Wenn es erforderlich ist, können für die einzelnen Bearbeitungsschritte nacheinander Trägerelemente wechselweise auf die Oberseite und die Unterseite des Erzeugnisses aufgebracht werden. Dadurch können abwechselnd die Oberseite und die Unterseite des Erzeugnisses mehrfach nacheinander mit den geschilderten Vorteilen bearbeitet werden.

Ein Ausführungsbeispiel für einen Verfahrensablauf nach der Erfindung ist in der Zeichnung dargestellt und wird im nachfolgenden näher beschrieben. Dabei zeigt:
Fig. 1 ein grob schematisches Ablaufdiagramm eines Beispiels für einen Ablauf eines Bearbeitungsverfahrens und
Fig. 2 eine grob schematische Darstellung zur Verdeutlichung der Anwendung des erfindungsgemäßen Verfahrens auf ein Erzeugnis der Halbleitertechnik.

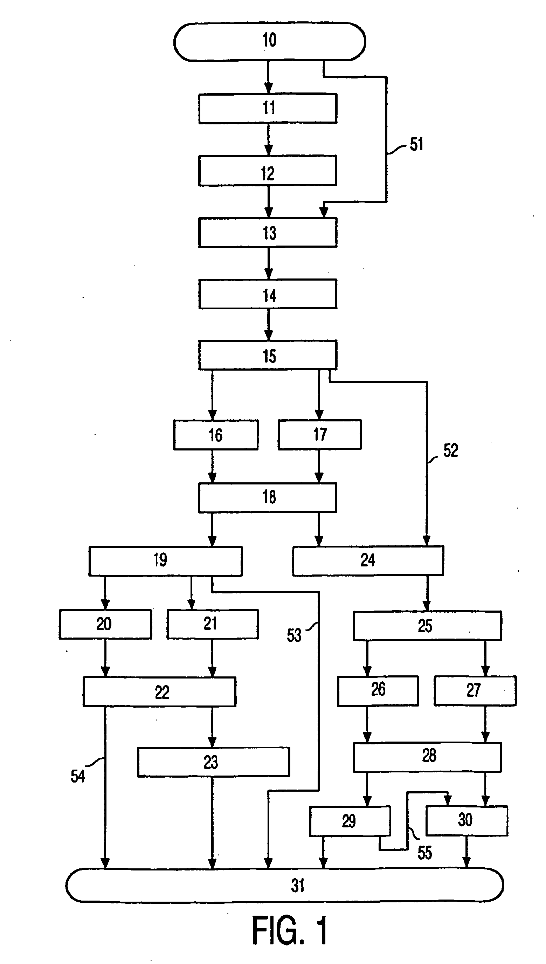

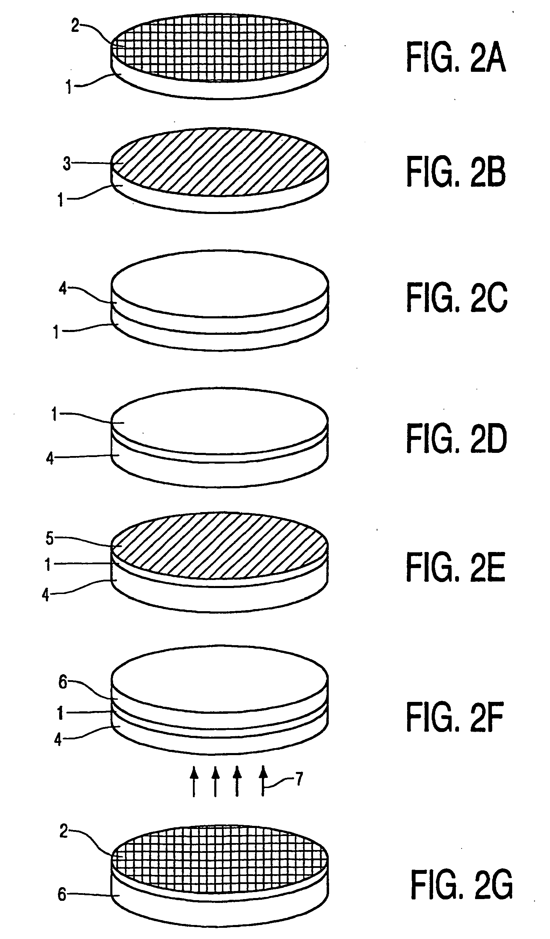

Das in Fig. 1 dargestellte Diagramm ist eine blockschematische Darstellung eines Teils eines Bearbeitungsverfahrens für ein Erzeugnis der Halbleitertechnik. Ausgangssituation des beispielhaft dargestellten Verfahrens ist ein wenigstens nahezu scheibenförmiges Halbleitererzeugnis, auf dessen erster Hauptfläche (Oberseite) eine Anzahl elektronischer Schaltungskörper gestaltet ist. Eine schematische Darstellung eines solchen Erzeugnisses findet sich in Fig. 2a). Darin ist mit dem Bezugszeichen 1 das Erzeugnis, beispielsweise ein Wafer aus halbleitendem Werkstoff, bezeichnet. Die erste Hauptfläche (Oberseite) ist mit dem Bezugszeichen 2 versehen. Auf der Oberseite 2 des Erzeugnisses 1 sind schematisch durch ein rechteckförmiges Linienmuster die einzelnen, dort gestalteten, elektronischen Schaltungskörper angedeutet. Diese Schaltungskörper sind in an sich bekannter Weise, beispielsweise durch Diffusion und dergleichen, gebildet. Fig. 2a) zeigt das Erzeugnis im Zustand unmittelbar nach Abschluß dieser Bearbeitungsschritte, die nicht Gegenstand der vorliegenden Erfindung sind und die daher auch nicht näher beschrieben werden sollen. Im Diagramm nach Fig. 1 ist dieser Ausgangszustand mit dem Block mit dem Bezugszeichen 10 symbolisiert.

In einem üblichen Bearbeitungsverfahren wird das Erzeugnis im folgenden in einem mit dem Bezugszeichen 13 versehenen Verfahrensschritt von seiner zweiten Hauptfläche (Unterseite) her einem flächigen Materialabtrag zum Abdünnen unterzogen, beispielsweise durch Schleifen, Läppen oder Ätzen. Die Aufeinanderfolge dieses Schrittes im Anschluß an den Ausgangszustand 10 ist mit dem Pfeil 51 bezeichnet.

Gemäß der Erfindung wird diese Aufeinanderfolge insoweit abgewandelt, daß im ersten Schritt nach dem Ausgangszustand 10 in einem Bearbeitungsschritt 11 auf die Oberseite 2 des Erzeugnisses 1 eine doppelt klebende Folie auflaminiert wird, die in Fig. 2b) mit dem Bezugszeichen 3 versehen ist. Diese doppelt klebende Folie 3 bildet ein adhäsives Material, auf welches im Bearbeitungsschritt 12, der dem Bearbeitungsschritt 11 folgt, ein erstes Trägerelement aufgebracht wird. Dieses erste Trägerelement ist in Fig. 2c) mit dem Bezugszeichen 4 versehen. Gemäß der Erfindung wird nun das Abdünnen im Verfahrensschritt 13 in Fig. 1 an dem auf das erste Trägerelement 4 aufgebrachten Erzeugnis 1 im Bearbeitungsschritt 13 durchgeführt. Das Ergebnis dieses Bearbeitungsschritts ist schematisch in Fig. 2d) wiedergegeben.

Im Anschluß an das Abdünnen des Erzeugnisses 1 von seiner Unterseite her erfolgt im nachfolgenden Bearbeitungsschritt 14 das Auflaminieren eines zweiten adhäsiven Materials, beispielsweise ebenfalls in Form einer doppelt klebenden Folie, auf der zweiten Hauptfläche (Unterseite) des Erzeugnisses 1. Diese zweite doppelt klebende Folie ist in Fig. 2e) mit dem Bezugszeichen 5 bezeichnet. Anschließend wird auch auf die doppelt klebende Folie 5 im Bearbeitungsschritt 15 ein Trägerelement, hier als zweites Trägerelement mit dem Bezugszeichen 6 in Fig. 2f) bezeichnet, aufgebracht. Wie Fig. 2f) schematisch zeigt, ist nach Abschluß des Bearbeitungsschritts 15 das Element 1 beidseitig mit je einem Trägerelement 4 bzw. 6 verbunden.

Da die nun folgende Bearbeitung des Erzeugnisses 1 an dessen Oberseite 2 erfolgen soll, ist es erforderlich, von dieser Oberseite 2 zunächst das erste Trägerelement 4 und auch das erste adhäsive Material 3 zu entfernen. Nicht erfindungsgemäß ist das erste adhäsive Material, im vorliegenden Beispiel also das auf der doppelt klebenden Folie 3 aufgebrachte Klebemittel, gegen ultraviolettes Licht empfindlich in der Weise, daß seine Klebkraft durch Bestrahlung mit ultraviolettem Licht herabgesetzt werden kann. Eine solche UV-Bestrahlung wird nun in dem mit dem Bezugszeichen 16 versehenen Bearbeitungsschritt durchgeführt. Das erste Trägerelement 4 muß dazu für ultraviolettes Licht durchlässig ausgebildet sein. Diese UV-Bestrahlung ist in Fig. 2f) mit den Pfeilen mit dem Bezugszeichen 7 symbolisiert.

Erfindungsgemäß wird anstelle des Bearbeitungsschrittes 16 in einem Bearbeitungsschritt 17 die Klebkraft eines entsprechend ausgebildeten, ersten adhäsiven Materials durch Zufuhr von Wärmeenergie herabgesetzt. Dazu ist für das erste adhäsive Material, d.h. beispielhaft die erste doppelt klebende Folie 3, ein Klebemittel mit einer Temperaturgrenze zu wählen, die niedriger liegt als die Temperaturgrenze des zweiten adhäsiven Materials 5.

Dadurch wird das Ergebnis erzielt, daß das erste Trägerelement 4 gemeinsam mit dem ersten adhäsiven Material 3, also der in ihrer Klebkraft verminderten doppelt klebenden Folie 3, von der Oberseite 2 des Erzeugnisses 1 entfernt werden können. Dies wird im Bearbeitungsschritt 18 vorgenommen. Das Erzeugnis 1 ist dann mit seiner Unterseite noch mit dem zweiten Trägerelement 6 verbunden. Die Oberseite liegt für weitere Bearbeitungsschritte frei. Dieser Zustand ist in Fig. 2g schematisch dargestellt.

In einer nicht erfindungsgemäßen Variante des in Fig. 1 dargestellten Verfahrens, welche die mit den Bezugszeichen 19 bis 23 bezeichneten Bearbeitungsschritte sowie die gemäß den Pfeilen 53, 54 abgewandelten Aufeinanderfolgen der genannten Bearbeitungsschritte umfaßt, wird das Erzeugnis in dem in Fig. 2g) dargestellten Bearbeitungszustand einer elektrischen Funktionsprüfung unterzogen, welche in Fig. 1 mit dem Bearbeitungsschritt mit dem Bezugszeichen 19 symbolisiert ist. Daran anschließend wird in einem Bearbeitungsschritt 20 die zweite Hauptfläche, d.h. die Unterseite, des Erzeugnisses 1 mit ultraviolettem Licht bestrahlt, um die Klebkraft der doppelt klebenden Folie 5 auf der Unterseite aufzuheben. Dieser Bearbeitungsschritt entspricht insoweit, bis auf die Hauptfläche des Erzeugnisses 1, auf die er angewendet wird, dem Bearbeitungsschritt 16. In einer Abwandlung kann statt dessen in einem wahlweise auszuführenden Bearbeitungsschritt 21 das zweite adhäsive Material (doppelt klebende Folie) 5 auf der Unterseite des Erzeugnisses 1 durch Zufuhr von Wärmeenergie zur Herabsetzung der Klebkraft behandelt werden. Sowohl dem Bearbeitungsschritt 20 als auch dem wahlweise durchzuführenden Bearbeitungsschritt 21 folgt im Bearbeitungsschritt 22 die Entfernung des zweiten Trägereelements 6 und des zweiten adhäsiven Materials 5 von der Unterseite des Erzeugnisses 1. Nach Durchführung dieses Bearbeitungsschrittes 22 liegt das Erzeugnis 1 in bis auf die mechanische Trennung der darauf gestalteten elektronischen Schaltungskörper fertigem Bearbeitungszustand vor, beispielsweise als Wafer aus Halbleitermaterial. Entsprechend der durch den Pfeil 54 symbolisierten Verfahrensvariante kann das Erzeugnis 1 unmittelbar zur Ablieferung, symbolisiert durch den Block 31 in Fig. 1, gelangen, oder es kann wahlweise vor der Ablieferung 31 in einem Bearbeitungsschritt 23 ein Trennen der auf dem Erzeugnis 1 gestalteten elektronischen Schaltungskörper erfolgen, beispielsweise durch Sägen des Wafers.

In einer nicht erfindungsgemäßen zweiten Variante kann gemäß dem Pfeil 53 in Fig. 1 die Ablieferung des Erzeugnisses 1 auch unmittelbar nach Durchführung der elektrischen Funktionsprüfung 19 erfolgen. Das Erzeugnis 1 ist dann noch auf dem zweiten Trägerelement 6 aufgebracht, und die elektronischen Schaltungskörper sind mechanisch noch nicht getrennt.

Eine erfindungsgemäße Ausgestaltung erfährt das Verfahren jedoch in einer durch die Bearbeitungsschritte 24 bis 30 in Fig. 1 symbolisierten Variante. In dieser Ausgestaltung schließt sich an die Entfernung des ersten adhäsiven Materials 3 und des ersten Trägerelements 4 von der Oberseite 2 des Erzeugnisses 1 im Bearbeitungsschritt 18 ein Bearbeitungsschritt 24 an, in dem die elektronischen Schaltungskörper, die auf der Oberseite 2 des Erzeugnisses 1 gestaltet sind, mechanisch getrennt werden, beispielsweise durch Sägen des Wafers aus Halbleitermaterial. Im Gegensatz zu dem Bearbeitungsschritt 23 erfolgt dieses mechanische Trennen jedoch in einem Stadium des Verfahrens, in dem das Erzeugnis 1 noch mit dem zweiten Trägerelement 6 verbunden ist. Dadurch bleiben die einzelnen elektronischen Schaltungskörper nach dem Trennen in ihrer geometrischen Position zueinander auf dem zweiten Trägerelement 6 unverändert. Dadurch können im anschließenden Bearbeitungsschritt 25, in dem eine elektrische Funktionsprüfung der elektronischen Schaltungskörper durchgeführt wird, grundsätzlich die gleichen Arbeitsschritte und Einrichtungen verwendet werden wie in dem zuvor beschriebenen Bearbeitungsschritt 19. Der Vorteil liegt jedoch darin, daß die mechanische Bearbeitung der elektronischen Schaltungskörper vollständig abgeschlossen ist und daß die elektrische Funktionsprüfung 25 auch Fertigungsfehler und Ausfälle erfaßt, die erst durch das mechanische Trennen entstehen, insbesondere durch Ausbröckeln beim Sägen eines Wafers aus Halbleitermaterial. Außerdem lassen sich auf diese Weise gerade auch Erzeugnisse, die aus besonders dünnen Scheiben aus Halbleitermaterial bestehen, mit den gängigen Bearbeitungseinrichtungen für Halbleitererzeugnisse behandeln, d.h. zumindest Prüfen und Trennen. Dies erleichtert die Bearbeitung der sehr bruchempfindlichen Erzeugnisse beträchtlich. Bei der elektrischen Funktionsprüfung 25 werden fehlerhafte Schaltungskörper in an sich üblicher Weise durch Farbmarkierungen kenntlich gemacht, oder ihre Lage innerhalb des gesamten Erzeugnisses 1 wird in einem Prüfprotokoll oder dergleichen niedergelegt, welches einem späteren Sortiervorgang der elektronischen Schaltkreise zugrunde gelegt werden kann (sogenannte Wafermap).

Die sich dem Bearbeitungsschritt 25 mit der elektrischen Funktionsprüfung wahlweise anschließenden Bearbeitungsschritte 26 und 27 beinhalten wieder das wahlweise Aufheben der Klebkraft des zweiten adhäsiven Materials (doppelt klebende Folie) 5 zwischen der Unterseite des Erzeugnisses 1 und dem zweiten Trägerelement 6. Dabei entspricht der Bearbeitungsschritt 26 in seiner Ausführung dem vorstehend beschriebenen Bearbeitungsschritt 20, nämlich einer nicht erfindungsgemäß UV-Bestrahlung der Unterseite des Erzeugnisses 1.

Der Bearbeitungsschritt 27 umfaßt entsprechend dem Bearbeitungsschritt 21 die Zufuhr von Wärmeenergie zu dem zweiten adhäsiven Material (doppelt klebende) Folie 5 zum Zwecke der Aufhebung der Klebkraft dieses Materials.

Als übereinstimmendes Ergebnis der Bearbeitungsschritte 26 und 27 liegen die nun mechanisch getrennten elektronischen Schaltungskörper des Erzeugnisses 1 zum Entfernen bereit auf dem zweiten Trägerelement 6. Dieses Entfernen wird im Bearbeitungsschritt 28 durchgeführt. Dies erfolgt bevorzugt durch Absammeln der im Bearbeitungsschritt 25 als einwandfrei erkannten Schaltungskörper mit Hilfe einer Vakuumpipette. Die einzelnen Schaltungskörper können dann in einem Bearbeitungsschritt 29 für die Ablieferung verpackt werden, wozu in üblicherweise tablett-, band- oder rollenförmige Träger zum Einsatz gelangen. Wahlweise können die elektronischen Schaltungskörper auch in einem Bearbeitungsschritt 30 unmittelbar zur Montage, beispielsweise in ein Gehäuse, gelangen, um in diesem Zustand zur Ablieferung 31 gebracht zu werden. Schließlich ist durch den Pfeil 55 eine weitere Variante angedeutet, nach der die elektronischen Schaltungskörper nach dem Verpacken 29 auf geeigneten Trägern zunächst einer Montageeinrichtung zugeleitet werden und erst nach der Montage 30 zur Ablieferung 31 gelangen. Weitere Varianten sind möglich.

Eine nicht erfindungsgemäße weitere Variante in der Aufeinanderfolge der beschriebenen Bearbeitungsschritte ist durch den Pfeil 52 in Fig. 1 angedeutet. Für den Fall, daß gemäß der durch den Pfeil 51 gegebenen Variante ein Trägerelement auf der Oberseite 2 des Erzeugnisses 1 nicht aufgebracht wurde, entfallen die Bearbeitungsschritte 16 bis 18. Bevorzugt wird dann nach dem Aufbringen des Trägerelements 6 auf die Unterseite des Elements 1 unmittelbar der Bearbeitungsschritt 24 durchgeführt, d.h. das mechanische Trennen der elektronischen Schaltungskörper.

Die Trägerelemente müssen, wie vorstehend beschrieben, derart formstabil sein, daß die Maßtoleranzen bei der Justierung insbesondere der Kontakteinrichtungen der elektronischen Schaltungskörper auf die elektrischen Kontaktvorrichtungen der benutzten Einrichtungen zum Durchführen elektrischer Prüfungsschritte eingehalten werden können. Dieser Forderung entspricht ein starres Trägerelement am besten. Dagegen wird ein flexibles Trägerelement leichter vom Erzeugnis 1 abzulösen sein, und zwar sowohl im ungetrennten Zustand als auch beim Absammeln der mechanisch getrennten elektronischen Schaltungskörper, insbesondere wenn die Klebkraft des zweiten adhäsiven Materials nicht völlig aufgehoben wurde. Die erfindungsgemäß eingesetzten Trägerelemente müssen einen Kompromiß zwischen diesen beiden Anforderungen bilden, d.h. ihnen gleichermaßen entsprechen. Die Trägerelemente werden daher bevorzugt formstabil, jedoch leicht flexibel ausgeführt.

Zum mechanischen Trennen der elektronischen Schaltungskörper auf dem Erzeugnis 1 sind Verfahren und Vorrichtungen bekannt, bei denen das Erzeugnis auf einem genormten Rahmen aufgespannt wird. Diese Rahmen, die auch als "Film Frame Carrier (FFC)" bezeichnet werden, weisen eine Folie auf, auf der herkömmlich zu bearbeitende Wafer aufgespannt werden. Diese FFC können unverändert auch zum Aufspannen der erfindungsgemäßen Verbindung aus Erzeugnis 1 und (bevorzugt) Trägerelement 6 auf der Unterseite des Erzeugnisses 1 eingesetzt werden. Ebenso kann aber das Trägerelement 6 so ausgestaltet werden, daß es unmittelbar einen FFC bildet.

In einer praktischen Ausführung des nicht erfindungsgemäßen Verfahrens wird ein Wafer aus halbleitendem Material auf seiner Oberseite 2 mit einer UV-Doppelfolie des Herstellers Furukawa als erstem adhäsivem Material 3 laminiert. Darauf wird eine Polykarbonatscheibe von 0,5 mm Dicke und transparenter Konsistenz als erstes Trägerelement 4 aufgebracht. Als zweites adhäsives Material 5 dient eine Temperatur-Doppelfolie des Herstellers Nitto, und das zweite Trägerelement 6 auf der Unterseite des Erzeugnisses 1 wird durch eine Glasscheibe von 0,5 mm Dicke gebildet. UV-Belichtung bzw. Zufuhr von Wärmeenergie erfolgen mit üblichen UV-Belichtungsanlagen bzw. Heizplatten:

## Patentansprüche

1. Verfahren zum Bearbeiten eines im wesentlichen scheibenförmigen Erzeugnisses der Halbleitertechnik, welches entlang wenigstens einer ersten seiner Hauptflächen zur Ausbildung einer Anzahl von im wesentlichen senkrecht zu der ersten Hauptfläche mechanisch zu trennenden, elektronischen Schaltungskörpern gestaltet ist und eine der ersten Hauptfläche gegenüberliegende zweite Hauptfläche aufweist, wobei
zur Durchführung von die erste der Hauptflächen des Erzeugnisses betreffenden Bearbeitungsvorgängen auf der zweiten Hauptfläche des Erzeugnisses ein schichtförmiges, adhäsives Material flächig aufgebracht wird, auf welches ein wenigstens weitgehend formstabiles Trägerelement zur flächigen Verbindung mit dieser zweiten Hauptfläche des Erzeugnisses aufgebracht wird,
nach Aufbringen des adhäsiven Materials und des Trägerelements auf der zweiten Hauptfläche das Erzeugnis entlang seiner ersten Hauptfläche einem Bearbeitungsschritt zum mechanischen Trennen der elektronischen Schaltungskörper unterzogen wird,
das Erzeugnis einem elektrischen Prüfungsschritt der elektronischen Schaltungskörper nach dem Bearbeitungsschritt zum mechanischen Trennen in derselben Weise wie für ein ungetrenntes Erzeugnis unterzogen wird und
die Klebkraft des adhäsiven Materials durch Zufuhr von Wärmeenergie herabsetzbar ist,
**dadurch gekennzeichnet, daß**
während wenigstens eines Bearbeitungsschrittes zugleich auf beiden Hauptflächen des Erzeugnisses je ein Trägerelement mit adhäsivem Material aufgebracht ist wobei zum Aufbringen der Trägerelemente auf die verschiedenen Hauptflächen des Erzeugnisses der Halbleitertechnik adhäsive Materialien unterschiedlicher Temperaturgrenzen eingesetzt werden wobei die Klebkraft der adhäsiver daß Materialien sich bei Überschreiten vorbestimmter Temperaturgrenzen-vorzugsweise irreversibel-vermindert, und daß das adhäsive Material, mit dem das im Laufe der weiteren Bearbeitung zuerst zu entfernende Trägerelement aufgebracht ist, die niedrigere Temperaturgrenze aufweist.

2. Verfahren nach Anspruch 1, **dadurch gekennzeichnet,**
**daß** als adhäsives Material eine beidseitig mit Klebemittel beschichtete Folie verwendet wird.

3. Verfahren nach einem der vorhergehenden Ansprüche, **gekennzeichnet durch** die zeitlich aufeinanderfolgende Durchführung der Bearbeitungsschritte:
a) flächiges Aufbringen eines ersten schichtförmigen, adhäsiven Materials auf die erste Hauptfläche des Erzeugnisses,
b) Aufbringen eines ersten Trägerelements auf das erste schichtförmige, adhäsive Material, **durch** welches zwischen der ersten Hauptfläche des Erzeugnisses und dem ersten Trägerelement eine flächige Verbindung gebildet wird,
c) mechanischer und/oder chemischer, vorzugsweise flächiger Materialabtrag auf der zweiten Hauptfläche des Erzeugnisses,
d) flächiges Aufbringen eines zweiten schichtförmigen adhäsiven Materials auf die zweite Hauptfläche des Erzeugnisses,
e) Aufbringen des wenigstens weitgehend formstabilen Trägerelements, im folgenden als zweites Trägerelement bezeichnet, auf das zweite schichtförmige, adhäsive Material, **durch** welches zwischen der zweiten Hauptfläche des Erzeugnisses und dem zweiten Trägerelement eine flächige Verbindung gebildet wird,
f) Herabsetzen der Klebkraft des ersten schichtförmigen, adhäsiven Materials **durch** Zufuhr von Wärmeenergie,
g) Entfernen des ersten schichtförmigen, adhäsiven Materials und des ersten Trägerelements von der ersten Hauptfläche,
h) mechanisches Trennen der auf der ersten Hauptfläche ausgebildeten elektronischen Schaltungskörper, vorzugsweise **durch** Sägen des Erzeugnisses,
i) elektrische Funktionsprüfung der mechanisch getrennten elektronischen Schaltungskörper im Verbund ihrer gegenüber dem ungesägten Erzeugnis unveränderten, räumlichen Position auf dem zweiten Trägerelement und kenntlich machen unbrauchbarer elektronischer Schaltungskörper,
j) Herabsetzen der Klebkraft des zweiten schichtförmigen, adhäsiven Materials **durch** Zufuhr von Wärmeenergie, wobei für das Herabsetzen der Klebkraft beider adhäsiver Materialien **durch** Zufuhr von Wärmeenergie bei dem ersten adhäsiven Material zum Vermindern der Klebkraft eine niedrigere Temperaturgrenze zu überschreiten ist als beim zweiten adhäsiven Material,
k) Entfernen der einzelnen elektronischen Schaltungskörper vom zweiten Trägerelement.

## Claims

1. A method of processing an in essence wafer-shaped product in semiconductor technology, which product is designed for the formation of a number of electronic circuit bodies along at least a first of its main surfaces, which circuit bodies are to be mechanically separated substantially perpendicularly to the first main surface, and which product has a second main surface lying opposite the first main surface, where,
for carrying out processing operations relating to the first of the main surfaces of the product, a layer of adhesive material is applied in a planar manner to the second main surface of the product on which material a carrier element of at least substantially stable shape is provided so as to achieve a planar connection to said second main surface of the product,
after application of the adhesive material to and provision of the carrier element onto the second main surface, the product is subjected to a processing step for mechanically separating the electronic circuit bodies along its first main surface,
the product is subjected to an electrical test step of the electronic circuit bodies after the processing step for mechanical separation in like manner to an unseparated product and the adhesive strength of the adhesive material can be reduced,
**characterized in that**,
during at least one processing step one carrier element each is simultaneously provided onto the two main surfaces of the product by means of adhesive material while, for providing the carrier elements onto the two main surfaces of the product of semiconductor technology, adhesive materials having different temperature limits are used, the adhesive strength of the adhesive materials - preferably irreversibly - diminishing when predefined temperature limits are exceeded, and **in that** the adhesive material by means of which the carrier element to be removed first in the course of the further processing has the lower temperature limit.

2. A method as claimed in claim 1, **characterized in that** a foil coated on both sides with an adhesive agent is used as the adhesive material.

3. A method as claimed in any one of the preceding claims, **characterized in that** the processing steps are carried out in a time sequence as defined below:
a) planar application of a first layer of adhesive material to the first main surface of the product,
b) provision of a first carrier element onto the first layer of adhesive material, whereby a planar connection is formed between the first main surface of the product and the first carrier element,
c) mechanical and/or chemical, preferably planar material removal from the second main surface of the product,
d) planar application of a second layer of adhesive material to the second main surface of the product,
e) provision of the at least substantially stable-shaped carrier element, to be referred to in the following as second carrier element, onto the second layer of adhesive material, whereby a planar connection is formed between the second main surface of the product and the second carrier element,
f) reduction of the adhesive strength of the first layer of adhesive material through the application of heat energy,
g) removal of the first layer of adhesive material and of the first carrier element from the first main surface,
h) mechanical separation of the electronic circuit bodies formed on the first main surface, preferably through sawing of the product,
i) electrical testing of the functions of the mechanically separated electronic circuit bodies which are still fixed in their unchanged spatial positions on the second carrier element as compared with the non-sawed product, and identification of unusable electronic circuit bodies,
j) reduction of the adhesive strength of the second layer of adhesive material through the application of heat energy, i.e. if the adhesive strength of both adhesive materials is to be reduced through the application of heat energy, a lower temperature limit for reducing the adhesive strength is to be exceeded for the first adhesive material than for the second adhesive material, and
k) removal of the individual electronic circuit bodies from the second carrier element.

## Revendications

1. Procédé d'usinage d'un produit de la technique des semi-conducteurs en forme générale de disque, qui est conçu le long d'au moins une première de ses faces principales pour la réalisation d'un nombre de corps de circuit électroniques, à séparer mécaniquement essentiellement perpendiculairement de la première face principale et présente une seconde face principale opposée à la première face principale,
pour réaliser les opérations d'usinage concernant la première des faces principales du produit, un matériau adhésif disposé en couches étant appliqué à plat sur la seconde face principale du produit, sur lequel est appliqué un élément porteur de forme stable au moins dans une large mesure pour la liaison à plat avec cette seconde face principale du produit,
après l'application du matériau adhésif et de l'élément porteur sur la seconde face principale, le produit étant soumis le long de sa première face principale à une étape d'usinage pour la séparation mécanique des corps de circuit électroniques,
le produit étant soumis à une étape de contrôle électrique des corps de circuit électroniques après l'étape d'usinage pour la séparation mécanique de la même manière que pour un produit non séparé et
le pouvoir adhésif du matériau adhésif pouvant être diminué par apport d'énergie thermique,
**caractérisé en ce que**
pendant au moins une étape d'usinage, un élément porteur avec un matériau adhésif est appliqué à la fois sur les deux faces principales du produit, des matériaux adhésifs aux limites thermiques différentes étant utilisés pour appliquer les éléments porteurs sur les différentes faces principales du produit de la technique des semi-conducteurs, le pouvoir adhésif des matériaux adhésifs se réduisant en cas de dépassement de limites thermiques prédéterminées de préférence de manière irréversible, et **en ce que** le matériau adhésif, avec lequel est appliqué l'élément porteur à retirer en premier lieu au cours de la suite de l'usinage, présente la limite thermique la plus basse.

2. Procédé selon revendication 1, **caractérisé en ce**
**qu'**un film revêtu sur les deux faces d'adhésif est utilisé comme matériau adhésif.

3. Procédé selon l'une quelconque des revendications précédentes, **caractérisé par** la réalisation successive des étapes d'usinage suivantes :
a) application à plat d'un premier matériau adhésif, disposé en couches sur la première face principale du produit,
b) application d'un premier élément porteur sur le premier matériau adhésif, disposé en couches, par lequel est constituée une liaison à plat entre la première face principale du produit et le premier élément porteur,
c) enlèvement de matière mécanique et/ou chimique, de préférence à plat sur la seconde face principale du produit,
d) application à plat d'un second matériau adhésif, disposé en couches sur la seconde face principale du produit,
e) application de l'élément porteur de forme stable au moins dans une large mesure, désigné par la suite par second élément porteur, sur le second matériau adhésif, disposé en couches, par lequel est constituée une liaison à plat entre la seconde face principale du produit et le second élément porteur,
f) diminution du pouvoir adhésif du premier matériau adhésif, disposé en couches par apport d'énergie thermique,
g) enlèvement du premier matériau adhésif, disposé en couches et du premier élément porteur de la première face principale,
h) séparation mécanique des corps de circuit électroniques réalisés sur la première face principale, de préférence par sciage du produit,
i) vérification du fonctionnement électrique des corps de circuit électroniques, séparés mécaniquement en liaison avec leur position spatiale, non modifiée par rapport au produit non scié sur le second élément porteur et marquage des corps de circuit électroniques inutilisables,
j) diminution du pouvoir adhésif du second matériau adhésif, disposé en couches par apport d'énergie thermique, pour la diminution du pouvoir adhésif des deux matériaux adhésifs, moyennant quoi une limite thermique doit être dépassée afin de réduire le pouvoir adhésif, ladite limite thermique étant plus basse pour le premier matériau adhésif que pour le deuxième matériau adhésif.
k) enlèvement des corps de circuit électroniques individuels du second élément porteur.
